(19) Europäisches Patentamt
European Patent Office
Office européen des brevets

(11) **EP 4 542 246 B1**

(12) **EUROPEAN PATENT SPECIFICATION**

(45) Date of publication and mention
of the grant of the patent:
**17.06.2026 Bulletin 2026/25**

(21) Application number: **23807736.6**

(22) Date of filing: **27.01.2023**

(51) International Patent Classification (IPC):
*G01R 31/392* (2019.01)  *G01R 31/396* (2019.01)
*G01R 31/3842* (2019.01)  *G01R 31/389* (2019.01)
*G01R 27/08* (2006.01)  *G01R 31/374* (2019.01)
*G01R 19/165* (2006.01)  *G01R 31/367* (2019.01)
*H01M 10/48* (2006.01)  *H01M 10/42* (2006.01)

(52) Cooperative Patent Classification (CPC):
**G01R 31/389; G01R 31/367; G01R 31/374;
G01R 31/3842; G01R 31/392; H01M 10/48;
H01M 10/486;** H01M 10/4285; Y02E 60/10

(86) International application number:
**PCT/KR2023/001313**

(87) International publication number:
**WO 2023/224211 (23.11.2023 Gazette 2023/47)**

(54) **BATTERY DIAGNOSIS METHOD, AND BATTERY DIAGNOSIS DEVICE AND BATTERY SYSTEM PROVIDING SAME METHOD**

BATTERIEDIAGNOSEVERFAHREN UND BATTERIEDIAGNOSEVORRICHTUNG SOWIE BATTERIESYSTEM MIT BEREITSTELLUNG DES VERFAHRENS

PROCÉDÉ DE DIAGNOSTIC DE BATTERIE, ET DISPOSITIF DE DIAGNOSTIC DE BATTERIE ET SYSTÈME DE BATTERIE FOURNISSANT LEDIT PROCÉDÉ

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **20.05.2022 KR 20220061918**

(43) Date of publication of application:
**23.04.2025 Bulletin 2025/17**

(73) Proprietor: **LG Energy Solution, Ltd.
Seoul 07335 (KR)**

(72) Inventor: **KIM, Dong Hyun
Daejeon 34122 (KR)**

(74) Representative: **Plasseraud IP
104 Rue de Richelieu
CS92104
75080 Paris Cedex 02 (FR)**

(56) References cited:
CN-B- 104 300 186    JP-A- 2008 256 673
JP-A- 2015 031 674    JP-B2- 5 017 084
JP-B2- 6 571 268    KR-A- 20210 054 930
KR-A- 20220 013 571    KR-A- 20220 060 814
KR-A- 20220 060 814    KR-B1- 101 835 656
US-A1- 2011 172 939    US-A1- 2012 004 875
US-A1- 2012 265 462    US-A1- 2018 203 070
US-A1- 2019 288 344    US-A1- 2021 300 205
US-A1- 2021 325 477

## Description

### [Technical Field]

CROSS-REFERENCE TO RELATED APPLICATION

This application claims priority to and the benefit of Korean Patent Application No. 10-2022-0061918 filed in the Korean Intellectual Property Office on May 20, 2022.

The present invention relates to a battery diagnosis method capable of diagnosing the state of a battery including a plurality of battery cells connected in parallel, and a battery diagnosis apparatus and a battery system for providing the method.

### [Background Art]

Large batteries to be mounted in electric vehicles, energy storage batteries, robots, satellites, and so on are required to be batteries having capacities higher than those of small batteries to be mounted in portable terminals, laptops, etc. High-capacity batteries may be configured by connecting a plurality of batteries in series and/or in parallel. In this case, the plurality of batteries may include a plurality of battery cells connected in parallel.

On the other hand, if the number of battery cells which are included in a battery increases, a defect may be caused in the battery by a battery cell's own problem and/or a connection problem between battery cells. For example, some defects such as a disconnection or a short between battery cells may occur. When a defect occurs in a battery, it is required to quickly diagnose and fix the defect such that a system including the battery (for example, a vehicle, an energy storage system, etc.) can be normally operated.

However, when a plurality of battery cells is connected in parallel, it is not easy to directly sense the cell voltages of the individual battery cells and so on because of the structural problems in the connection, etc. In other words, it is difficult to directly estimate battery cells' own defects in order to diagnose defects in the entire battery.

Further, a technique of diagnosing defects in batteries by estimating direct current internal resistance (DCIR) in each battery and comparing the estimated direct current internal resistance (DCIR) value with a predetermined (fixed) reference value has a limitation that it cannot detect defects when multiple battery cells in a battery are disconnected or short-circuited at the same time. Furthermore, a problem of misdiagnosing the degree of change in the direct current internal resistance value due to aging as a defect may occur.

In addition, the technique of diagnosing defects in batteries on the basis of the direct current internal resistance (DCIR) values of the batteries has a problem that when the external temperature changes rapidly, since the margin of error range becomes too large according to the states of charge (SOCs) of batteries and so on, the diagnosis is not accurate.

The document KR10-2022-0013571 discloses a system and a method for diagnosing a battery.

### [Disclosure]

### [Technical Problem]

The present invention has been made in an effort to provide a battery diagnosis method having advantages of being able to accurately diagnose the state of a battery including a plurality of battery cells connected in parallel, and a battery system for providing the method.

### [Technical Solution]

An exemplary embodiment of the present invention provides a battery diagnosis apparatus including a measuring unit that measures a battery voltage which is the voltage between both terminals of a battery including a plurality of battery cells, a battery current that is a current flowing through the battery, and a battery temperature which is the temperature of the battery, a storage unit that stores an internal resistance value calculated on the basis of the battery voltage and the battery current, and an environment data item which is a factor affecting the internal resistance value, at each diagnosis time of diagnosing defects of the battery, and a control unit that extracts, at each diagnosis time, a plurality of diagnosis times satisfying a first condition that environment data corresponding to environment data at the diagnosis time in a predetermined range should be included, and a second condition that the plurality of diagnosis times should be previous diagnosis times corresponding to a predetermined number of samples from the diagnosis time, and calculates a moving average which is the average of a plurality of internal resistance values corresponding to the plurality of diagnosis times, respectively, and diagnoses defects of the battery by comparing the internal resistance value, which is calculated at each diagnosis time, with an upper band threshold larger than the moving average by a predetermined value and a lower band threshold smaller than the moving average by a predetermined value, and the environment data includes at least one of the state of charge (SOC) of the battery estimated by a predetermined method, and the battery temperature.

Another exemplary embodiment of the present invention provides a battery system including a battery that includes a plurality of battery cells, a measuring unit that measures a battery voltage which is the voltage between both terminals of the battery, a battery current that is a current flowing through the battery, and a battery temperature which is the temperature of the battery, a storage unit that stores an internal resistance value calculated on the basis of the battery voltage and the battery current, and an environment data item which is a factor affecting the internal resistance value, at each diagnosis time of diagnosing defects of the battery, and a control unit that extracts, at each diagnosis time, a plurality of diagnosis times satisfying a first condition that environment data corresponding to environment data at the diagnosis time in a predetermined range should be included, and a second condition that the plurality of diagnosis times should be previous diagnosis times corresponding to a predetermined number of samples from the diagnosis time, and calculates a moving average which is the average of a plurality of internal resistance values corresponding to the plurality of diagnosis times, respectively, and diagnoses defects of the battery by comparing the internal resistance value calculated at each diagnosis time with an upper band threshold larger than the moving average by a predetermined value and a lower band threshold smaller than the moving average by a predetermined value, and the environment data includes at least one of the state of charge (SOC) estimated by a predetermined method, and the battery temperature.

The control unit may calculate an error value by multiplying a standard deviation average which is the average of a plurality of standard deviations corresponding to the plurality of diagnosis times, respectively, by a predetermined multiple, and calculate the upper band threshold by adding the error value to the moving average, and calculate the lower band threshold by subtracting the error value from the moving average.

Yet another exemplary embodiment of the present invention provides a battery diagnosis method including a battery data collecting step of collecting measurement values of battery voltage which is the voltage between both terminals of a battery, battery current which is the current flowing through the battery, and battery temperature which is the temperature of the battery, a sample set determining step of extracting a plurality of diagnosis times satisfying a first condition that environment data belonging to environment data at the diagnosis time in a predetermined range should be included, and a second condition that the plurality of diagnosis times should be previous diagnosis times corresponding to a predetermined number of samples from the diagnosis time, a reference value determining step of calculating a moving average which is the average of a plurality of internal resistance values corresponding to the plurality of diagnosis times, respectively, and an upper band threshold which is larger than the moving average by a predetermined value, and a lower band threshold which is smaller than the moving average by a predetermined value, and a defect diagnosis step of diagnosing defects of the battery by comparing an internal resistance value corresponding to the diagnosis time with the upper band threshold and the lower band threshold, and the environment data includes at least one of the state of charge (SOC) of the battery estimated by a predetermined method, and the battery temperature.

The reference value determining step may calculate an error value by multiplying a standard deviation average which is the average of a plurality of standard deviations corresponding to the plurality of diagnosis times, respectively, by a predetermined multiple, and calculate the upper band threshold by adding the error value to the moving average, and calculate the lower band threshold by subtracting the error value from the moving average.

The sample set determining step may determine that the first condition is satisfied, when a battery temperature at a predetermined diagnosis time belongs to a predetermined temperature range including a battery temperature at the diagnosis time among a plurality of temperature ranges set at a predetermined temperature interval.

The sample set determining step may determine that the first condition is satisfied, when the state of charge at a predetermined diagnosis time belongs to a predetermined state-of-charge range including the state of charge at the diagnosis time among a plurality of state-of-charge ranges set at a predetermined state-of-charge interval.

When an internal resistance value corresponding to the diagnosis time exceeds the upper band threshold, the defect diagnosis step may diagnose that a disconnection defect has occurred at, at least one of a plurality of battery cells included in the battery.

When an internal resistance value corresponding to the diagnosis time is smaller than the lower band threshold, the defect diagnosis step may diagnose that a short defect has occurred at, at least one of a plurality of battery cells included in the battery.

## [Advantageous Effects]

The present invention can accurately diagnose defects of batteries even when a plurality of battery cells is connected in parallel.

Unlike the prior art of diagnosing defects of batteries using fixed reference values, at each diagnosis time of diagnosing defects of a battery, the present invention sets reference values reflecting a change in the internal resistance value of the battery, to diagnose defects of the battery. Therefore, it is possible to diagnose defects of a battery with high accuracy by taking consideration of the degree of aging of the battery according to the period of use. The present invention sets reference values reflecting a change in the internal resistance value of a battery calculated in an environment (for example, temperature, SOC, etc.) similar to that at the current defect diagnosis time of a plurality of defect diagnosis times, diagnoses defects of the battery on the basis of the calculated reference values, thereby being capable of reducing the problem of misdiagnosing a difference in the external environment as a defect of the battery.

[Description of the Drawings]

FIG. 1 is a drawing for explaining a battery diagnosis apparatus according to an exemplary embodiment.
FIG. 2 is a drawing for explaining a battery system according to another exemplary embodiment.
FIG. 3 is a drawing illustrating an example of a cumulative display of moving averages, upper band thresholds, and lower band thresholds calculated at a plurality of diagnosis times, respectively.
FIG. 4 is a flow chart for explaining a battery diagnosis method according to an exemplary embodiment.
FIG. 5 is a flow chart for explaining the reference value determining step S300 of FIG. 4 in detail.

[Mode for Invention]

Hereinafter, exemplary embodiments disclosed in this specification will be described in detail with reference to the accompanying drawings; however, the same or similar constituent components are denoted by the same or similar reference symbols, and a repeated description thereof will not be made. As used herein, the suffix 'module' and/or the suffix 'unit' for constituent elements are given and used interchangeably in consideration of only ease of preparing this specification, and the suffixes themselves do not have meanings or roles distinguishable from each other. Further, when describing exemplary embodiments disclosed in this specification, detailed descriptions of publicly known technologies will be omitted if it is determined that specific description thereof may obscure the gist of the exemplary embodiments disclosed in this specification. Furthermore, the accompanying drawings are provided for helping to easily understand exemplary embodiments disclosed in the present specification.

Terms including an ordinal number, such as first and second, are used for describing various constituent elements, but the constituent elements are not limited by the terms. The terms are used only to discriminate one constituent element from another constituent element.

When a constituent element is referred to as being "connected" or "coupled" to another constituent element, it will be appreciated that it may be directly connected or coupled to the other constituent element or intervening other constituent elements may be present. In contrast, when a constituent element is referred to as being "directly connected" or "directly coupled" to another constituent element, it will be appreciated that there are no intervening other constituent elements present.

In the present application, it will be appreciated that terms "including" and "having" are intended to designate the existence of characteristics, numbers, steps, operations, constituent elements, and components described in the specification or a combination thereof, and do not exclude a possibility of the existence or addition of one or more other characteristics, numbers, steps, operations, constituent elements, and components, or a combination thereof in advance.

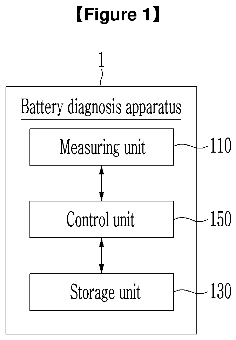

FIG. 1 is a drawing for explaining a battery diagnosis apparatus according to an exemplary embodiment.

Referring to FIG. 1, a battery diagnosis apparatus 1 includes a measuring unit 110, a storage unit 130, and a control unit 150.

The measuring unit 110 may measure a battery voltage which is the voltage between both terminals of a battery, a battery temperature, a battery current which is a current flowing through a battery, and so on. Battery voltages and battery currents may be battery data required to calculate the internal resistance or states of charge (SOCs) of batteries. Battery temperatures may be battery data for determining environment sections to be described below. For example, internal resistance may include direct current internal resistance (DCIR).

The measuring unit 110 may include a voltage sensor (not shown in the drawings) which is electrically connected between both terminals of a battery and measures the battery voltage, a current sensor (not shown in the drawings) which is connected to a battery in series and measures the battery current, and a temperature sensor (not shown in the drawings) which is positioned in the vicinity of a battery and measures the battery temperature. For example, at each diagnosis time of diagnosing defects of a battery, the measuring unit 110 may measure the battery voltage, the battery current, and the battery temperature, and transmit the measurement results to the control unit 150.

In the storage unit 130, internal resistance values and environment data may be stored. Environment data may include information on environmental factors affecting internal resistance values, such as battery temperature and the state of charge (SOC).

At each diagnosis time of diagnosing defects of a battery, the control unit 150 may use at least one of the battery voltage, the battery current, and the battery temperature to calculate an internal resistance value, which may be stored in the storage unit 130. The control unit 150 may use at least one of the battery voltage and the battery current to estimate the state of charge (SOC), which may be stored in the storage unit 130. Also, at each diagnosis time of diagnosing defects of a battery, the control unit 150 may store a battery voltage value, a battery current value, and a battery temperature value received from the measuring unit 110, in the storage unit 130.

When a diagnosis time (N) according to a predetermined condition comes, the control unit 150 calculates a moving average MA, an upper band threshold UB_Th larger than the moving average by a predetermined value, a lower band threshold LB_Th smaller than the moving average by a predetermined value, and an internal resistance value corresponding to the diagnosis time (N).

According to the exemplary embodiment, a time when charging of a battery starts, or a time when discharging of a battery ends may be a diagnosis time (N) of diagnosing defects of the battery. When a diagnosis time (N) comes, the measuring unit 110 may measure a battery voltage, a battery current, and a battery temperature at intervals of a predetermined time for a predetermined period, and transmit the measurement results to the control unit 150.

First, the control unit 150 may determine a sample set by extracting a plurality of diagnosis times which is included in the predetermined number of samples SN when an environment data item belongs to an environment section including the environment data item of the current diagnosis time (N) among a plurality of environment sections and diagnosis times are counted from the current diagnosis time (N) toward the previous diagnosis times. At this time, the number of samples SN may be the number of a plurality of diagnosis times which is included in a sample set, and be set to an optimal number based on experiments and so on. A sample set may be a set of some of a plurality of past diagnosis times constituting a population, and be a set for calculating a moving average MA, a standard deviation average $\sigma\_ave$, and so on to be described below.

Hereinafter, Table 1 is an example of battery temperatures, states of charge (SOCs), internal resistance (DCIR) values, moving averages MA, upper band thresholds UB_Th, and lower band thresholds LB_Th measured, estimated, and calculated at a plurality of diagnosis times, respectively. It is assumed that the number of samples SN is 5, and a plurality of temperature ranges (for example, a range from 0°C to 20°C, a range from 21°C to 40°C, a range from 41°C to 60°C, etc.) separated by a predetermined temperature interval (for example, the interval of 20°C) is set, and a plurality of state-of-charge ranges (for example, a range from 11% to 30%, a range from 31% to 50%, a range from 51% to 70%, and a range from 71% to 90%) separated by a predetermined SOC interval (for example, the interval of 20%) is set.

According to an exemplary embodiment, in the following Table 1, it is assumed that environment data includes battery temperature and the state of charge (SOC).

For reference, in Table 1, the moving average MA, the standard deviation $\sigma$, the standard deviation average $\sigma\_ave$, the upper band threshold UB_Th, and the lower band threshold LB_Th at the initial diagnosis time (1) may be difficult to be directly calculated (for this reason, the cells in Table 1 corresponding to those values are shown as blank), and the moving averages MA, the standard deviations $\sigma$, the standard deviation averages $\sigma\_ave$, the upper band thresholds UB_Th, and the lower band thresholds LB_Th at diagnosis times (2, 3, ⋯) close to the initial diagnosis time (1) may also be difficult to be directly calculated since there is none or a lack of past diagnosis values for calculation. In this case, values which are calculated on average according to experiments may substitute for the moving averages MA, the standard deviations $\sigma$, the standard deviation averages $\sigma\_ave$, the upper band thresholds UB_Th, and the lower band thresholds LB_Th at the early diagnosis times (1, 2, 3, ⋯). Furthermore, example values of internal resistance values, moving averages, and so on at the (N-8)-th diagnosis time which are not used in the following description are omitted.

(Table 1)

| Diagnosis Interval | | N | N-1 | N-2 | N-3 | N-4 | N-5 | N-6 | N-7 | N-8 | … | 1 |
|---|---|---|---|---|---|---|---|---|---|---|---|---|
| Environment | Temperature | 25 | 23 | 23 | 20 | 8 | 22 | 23 | 24 | 25 | | |
| | SOC | 60 | 55 | 55 | 50 | 60 | 55 | 11 | 53 | 50 | | |
| Internal Resistance (DCIR) | | ① | 23 | 21 | 20 | 24 | 23 | 27 | 25 | 15 | … | |
| Moving Average (MA) | | ② | 24 | 22 | 23 | 23.5 | 22 | 21 | 22.5 | | … | |
| Standard Deviation ($\sigma$) | | ③ | 1.63 | 1.73 | 1.82 | 1.60 | 1.70 | 1.60 | 1.56 | | … | |
| Standard Deviation Average ($\sigma\_ave$) | | ④ | 1.55 | 1.65 | 1.70 | 1.62 | 1.65 | 1.62 | 1.55 | | … | |
| Upper Band Threshold (UB_Th) | | ⑤ | 28.65 | 26.95 | 28.1 | 27.90 | 26.95 | 26.20 | 27.15 | | … | |
| Lower Band Threshold (LB_Th) | | ⑥ | 19.35 | 17.05 | 17.9 | 19.1 | 17.05 | 15.8 | 17.85 | | | |
| Diagnosis Result | | ⑦ | Normal | Normal | Normal | Normal | Normal | Abnormal | Normal | | | |

In the above Table 1, the temperature range in which the battery temperature (25°C) at the current diagnosis time (N) falls is the range from 21°C to 40°C. Furthermore, the state-of-charge range in which the SOC (60%) at the current diagnosis time (N) falls is the range from 51% to 70%.

The control unit 150 may determine a sample set by extracting the (N-1)-th diagnosis time, the (N-2)-th diagnosis time, the (N-3) diagnosis time, the (N-5)-th diagnosis time, and the (N-7)-th diagnosis time and correspond to five which is the number of samples SN when counting diagnosis times from the current diagnosis time (N), i.e., the N-th diagnosis time toward the previous diagnosis times while belonging to an environment (the range from 21°C to 40°C and the range from 51% to 70%) similar to that at the diagnosis time (N). In this case, in the case of the (N-4)-th diagnosis time, the corresponding battery temperature (8°C) belongs to a temperature range (the range from 0°C to 20°C) different from a temperature range (the range from 21°C to 40°C) to which the battery temperature (25°C) at the N-th diagnosis time belongs. In the case of the (N-6)-th diagnosis time, the corresponding SOC (11%) belongs to a state-of-charge range (the range from 11% to 30%) different from a state-of-charge range (the range from 51% to 70%) to which the SOC (60%) at the N-th diagnosis time belongs. The (N-8)-th diagnosis time is in an environment (the range from 21°C to 40°C and the range from 51% to 70%) similar to that at the N-th diagnosis time; however, since the (N-8)-th diagnosis time has a large time interval from the N-th diagnosis time, the (N-8)-th diagnosis time cannot be included in the number of samples SN. In other words, the (N-4)-th diagnosis time, the (N-6)-th diagnosis time, and the (N-8)-th diagnosis time cannot be included in the sample set.

According to another exemplary embodiment, environment data may include battery temperature or the state of charge (SOC). For example, in the above Table 1, when it is assumed that environment data includes only battery temperature, the control unit 150 may include the (N-1)-th diagnosis time (23°C), the (N-2)-th diagnosis time (23°C), the (N-3) diagnosis time (20°C), the (N-5)-th diagnosis time (22°C), and the (N-6)-th diagnosis time (23°C) belonging to an environment (the range from 21°C to 40°C) similar to that the N-th diagnosis time, in the sample set. As another example, in the above Table 1, when it is assumed that environment data includes only the state of charge (SOC), the control unit 150 may include the (N-1)-th diagnosis time (55%), the (N-2)-th diagnosis time (55%), the (N-3) diagnosis time (50%), the (N-4)-th diagnosis time (60%), and the (N-5)-th diagnosis time (55%) belonging to an environment (the range from 51% to 70%) similar to that at the N-th diagnosis time, in the sample set.

To sum up, the control unit 150 may determine a sample set by extracting a plurality of diagnosis times which is close to the predetermined diagnosis time (N) while being in an environment similar to that at the diagnosis time (N). For example, the control unit 150 may determine a sample set by extracting a plurality of diagnosis times (N-7, N-5, N-3, N-2, and N-1) according to the above-described criteria, and determine reference values (an upper band threshold and a lower band threshold to be described below) to be used for defect diagnosis, on the basis of the internal resistance values calculated at the plurality of diagnosis times included in the sample set. Then, it is possible to solve the problem of misdiagnosing the degree of aging according to long-term use of a battery and/or a temporary change in the internal resistance value as a defect of the battery.

Subsequently, the control unit 150 determines reference values (an upper band threshold and a lower band threshold) for diagnosing defects of the battery at the N-th diagnosis time, on the basis of the internal resistance values calculated at each of the plurality of diagnosis times (N-7, N-5, N-3, N-2, and N-1) belonging to the sample set.

According to the exemplary embodiment, the control unit 150 compares the internal resistance (DCIR) value corresponding to the N-th diagnosis time with the upper band threshold UB_Th and the lower band threshold LB_Th to diagnose defects of the battery. For example, referring to Table 1, at the N-th diagnosis time, the control unit 150 calculates the internal resistance value (①), the upper band threshold (⑤), and the lower band threshold (⑥), and compares the calculated internal resistance value (①) with the upper band threshold (⑤) and the lower band threshold (⑥) to diagnose defects of the battery. At this time, in order to calculate the upper band threshold (⑤) and the lower band threshold (⑥), the moving average (②) and the standard deviation average (④) are required. However, the standard deviation (③) is not a value necessary during defect diagnosis at the N-th diagnosis time; however, since it is necessary during defect diagnosis at the subsequent diagnosis times (N+1, N+2, ⋯), it may be calculated at the N-th diagnosis time and be stored in the storage unit 130. Hereinafter, the internal resistance value (①), the moving average (②), the standard deviation (③), the standard deviation average (④), the upper band threshold (⑤), and the lower band threshold (⑥) in Table 1 which the control unit 150 calculates at the N-th diagnosis time will be described.

The control unit 150 may calculate an internal resistance ($DCIR_N$) value corresponding to the N-th diagnosis time, on the basis of a battery voltage which is the voltage between both terminals of a battery and a battery current which is the current flowing through the battery. For example, the internal resistance ($DCIR_N$, ①) value may be calculated by the following Equation 1.

$$DCIR_N = \frac{\Delta V}{I}$$ - Equation 1

For example, the control unit 150 may calculate the voltage difference between a battery voltage V1 corresponding to a first time when charging starts and a battery voltage V2 corresponding to a second time that is a predetermined time later from the first time ($\Delta V = |V1 - V2|$). The control unit 150 may calculate the internal resistance ($DCIR_N$) value on the basis of the charging current I flowing through the battery and the voltage difference $\Delta V$. For example, it is assumed that $30\Omega$ is calculated as the internal resistance ($DCIR_N$) value corresponding to the N-th diagnosis time.

Referring to Table 1, the control unit 150 may calculate a moving average $MA_N$ (②) corresponding to the diagnosis time (N) by averaging the plurality of internal resistance values ($25\Omega$, $23\Omega$, $20\Omega$, $21\Omega$, and $23\Omega$) corresponding to the plurality of diagnosis times (N-7, N-5, N-3, N-2, and N-1) belonging to the sample set (($25\Omega + 23\Omega + 20\Omega + 21\Omega + 23\Omega$) / 5 = 22.4 $\Omega$). In other words, the moving average $MA_N$ corresponding to the N-th diagnosis time may be $22.4\Omega$.

$$MA_N = \frac{DCIR_{N-7} + DCIR_{N-5} + DCIR_{N-3} + DCIR_{N-2} + DCIR_{N-1}}{SN}$$

- Equation 2

Referring to the following Table 2, the control unit 150 may calculate a standard deviation $\sigma_N$ (③) corresponding to the diagnosis time (N), on the basis of the internal resistance values (DCIR) and the moving averages $MA_N$ corresponding to the plurality of diagnosis times (N-7, N-5, N-3, N-2, and N-1) belonging to the sample set, respectively.

(Table 2)

|  | N-7 | N-5 | N-3 | N-2 | N-1 | N |
|---|---|---|---|---|---|---|
| Internal Resistance (DCIR) | 25 | 23 | 20 | 21 | 23 |  |
| \|DCIR-MA\| | \|25-22.4\| =2.6 | \|23-22.4\| =0.6 | \|20-22.4\| =2.4 | \|21-22.4\| =1.4 | \|23-22.4\| =0.6 |  |
| (DCIR-MA)$^2$ | $(2.6)^2$ = 6.76 | $(0.6)^2$ = 0.36 | $(2.4)^2$ = 5.76 | $(1.4)^2$ = 1.96 | $(0.6)^2$ = 0.36 |  |
| Dispersion | (6.76 + 0.36 + 5.76 + 1.96 + 0.36) / 5 = 3.04 | | | | |  |
| Standard De-viation ($\alpha_N$) | $\sqrt{3.04}$ =1.74355957742 ($\approx$ 1.74) | | | | | 1.74 |

As described above, the standard deviation $\sigma_N$ (③) corresponding to the diagnosis time (N) is not a value necessary for defect diagnosis at the N-th diagnosis time, but is necessary for defect diagnosis at the subsequent diagnosis times (N+1, N+2. ···). Therefore, the standard deviation $\sigma_N$ (③) corresponding to the diagnosis time (N) may be calculated at the N-th diagnosis time and be stored in the storage unit 130.

Referring to the following Table 3, the control unit 150 may calculate the standard deviation average $\sigma_{N\_ave}$ (④) corresponding to the diagnosis time (N), on the basis of the plurality of standard deviations ($\sigma_{N-7}$, $\sigma_{N-5}$, $\sigma_{N-3}$, $\sigma_{N-2}$, and $\sigma_{N-1}$) corresponding to the plurality of diagnosis times (N-7, N-5, N-3, N-2, and N-1) belonging to the sample set, respectively.

(Table 3)

|  | N-7 | N-5 | N-3 | N-2 | N-1 | N |
|---|---|---|---|---|---|---|
| Standard Deviation ($\sigma$) | 1.56 | 1.70 | 1.82 | 1.73 | 1.63 |  |
| Standard Deviation Average ($\sigma_{N\_ave}$) | (1.56 + 1.70 + 1.82 + 1.73 + 1.63) / 5 = 1.688 ($\approx$ 1.69) | | | | | 1.69 |

The control unit 150 may calculate an upper band threshold $UB_{N\_}Th$ larger than the moving average $MA_N$ by a predetermined value, and a lower band threshold $LB_{N\_}Th$ smaller than the moving average $MA_N$ by a predetermined value. According to the exemplary embodiment, the control unit 150 may calculate a first error value by multiplying the standard deviation average $\sigma_{N\_ave}$ by the predetermined first multiple, and calculate an upper band threshold $UB_{N\_}Th$ by adding the first error value to the moving average $MA_N$. Also, the control unit 150 may calculate a second error value by multiplying the standard deviation average $\sigma_{N\_ave}$ by a predetermined second multiple, and calculate a lower band threshold $LB_{N\_}Th$ by subtracting the second error value from the moving average $MA_N$. In this case, the first multiple and the second multiple may be the same, but are not limited thereto, and may be set to various multiples.

According to the exemplary embodiment, the control unit 150 may calculate an error value E (= $\sigma_{N\_ave} \times Q$) by multiplying the standard deviation average $\sigma_{N\_ave}$ which is the average of the standard deviations of the sample set and a predetermined multiple Q together. In this case, the multiple Q may be a value for reflecting a predetermined error, and may be set to various values by experiments. For example, it is assumed that the multiple Q is a natural number 3.

The control unit 150 may calculate an upper band threshold ($UB_{N\_}Th$) 27.47 by adding the error value E (= $\sigma_{N\_ave} \times Q = 1.69 \times 3$) to the moving average $MA_N$ (= 22.4) of the sample set, as shown in the following Equation 3. Also, the control unit 150 may calculate a lower band threshold ($LB_{N\_}Th$) 17.33 by subtracting the error value E (= $\sigma_{N\_ave} \times Q = 1.69 \times 3$) from the moving average $MA_N$ (= 22.4) of the sample set, as shown in the following Equation 4.

$$UB_N\_Th = MA_N + (\sigma_{N\_ave} \times Q) \quad \text{- Equation 3}$$

$$LB_N\_Th = MA_N - (\sigma_{N\_ave} \times Q) \quad \text{- Equation 4}$$

Subsequently, the control unit 150 may diagnose defects of the battery by comparing the internal resistance ($DCIR_N$) value corresponding to the N-th diagnosis time with the upper band threshold $UB_{N\_}Th$ and the lower band threshold $LB_{N\_}Th$ corresponding to the N-th diagnosis time.

According to the exemplary embodiment, when the internal resistance ($DCIR_N$) value exceeds the upper band threshold $UB_{N\_}Th$, the control unit 150 may diagnose that a disconnection defect DD has occurred at, at least one of the plurality of battery cells included in the battery. When the internal resistance ($DCIR_N$) value is smaller than the lower band threshold $LB_{N\_}Th$, the control unit 150 may diagnose that a short defect SD has occurred at, at least one of the plurality of battery cells included in the battery. In other words, when the internal resistance ($DCIR_N$) value is out of a normal range from the lower band threshold $LB_{N\_}Th$ to the upper band threshold $UB_{N\_}Th$, the control unit 150 may diagnose that a defect (a disconnection defect or a short defect) has occurred in the battery. Also, when the internal resistance ($DCIR_N$) value is in the normal range, the control unit 150 may diagnose that the state of the battery is normal.

For example, as described above through Table 1, Table 3, and Equation 1 to Equation 4, 30 ($\Omega$), 27.47, and 17.33 may be calculated as the internal resistance ($DCIR_N$) value, the upper band threshold $UB_{N\_}Th$, and the lower band threshold $LB_{N\_}Th$ corresponding to the N-th diagnosis time, respectively. In this case, since the internal resistance value ($DCIR_N = 30$) exceeds the upper band threshold ($UB_{N\_}Th = 27.47$), the control unit 150 may diagnose a disconnection defect of the battery.

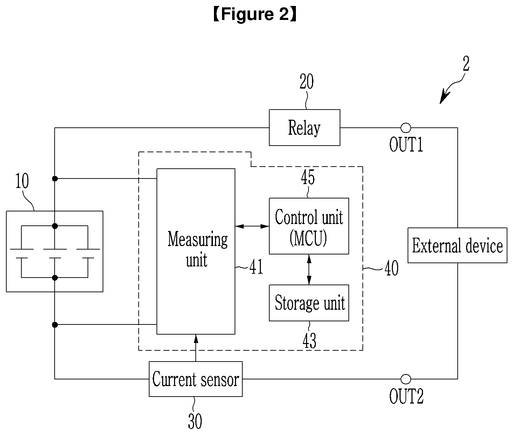

FIG. 2 is a drawing for explaining a battery system according to another exemplary embodiment.

Referring to FIG. 2, a battery system 2 includes a battery 10, a relay 20, a current sensor 30, and a battery management system (hereinafter, referred to as a BMS) 40.

The battery 10 may include a plurality of battery cells connected in series and/or in parallel. In FIG. 2, three battery cells connected in parallel are shown; however, the invention is not limited thereto, and the battery 10 may include various numbers of battery cells connected in series and/or in parallel. In some exemplary embodiments, the battery cells may be rechargeable secondary batteries.

For example, the battery 10 may be a battery pack configured to supply desired power to an external device by forming battery banks each of which is composed of a predetermined number of battery cells connected in parallel and connecting a predetermined number of battery banks in series. For another example, the battery 10 may be a battery pack configured to supply desired power to an external device by forming battery banks each of which is composed of a predetermined number of battery cells connected in parallel and connecting a predetermined number of battery banks in parallel. However, the invention is not limited to these connections, and the battery 10 may include a plurality of battery banks each of which includes a plurality of battery cells connected in series and/or in parallel, the plurality of battery banks may also be connected in series and/or in parallel.

In FIG. 2, the battery 10 is connected between two output terminals OUT1 and OUT2 of the battery system 2. Further, the relay 20 is connected between the positive electrode of the battery10 and the first output terminal OUT1, and the current sensor 30 is connected between the negative electrode of the battery 10 and the second output terminal OUT2. The components and the connection relationship among the components shown in FIG. 2 are an example, and the invention is not limited thereto.

The relay 20 controls the electrical connection between the battery system 2 and an external device. When the relay 20 is turned on, the battery system 2 and the external device are electrically connected such that charging or discharging is performed, and when the relay 20 is turned off, the battery system 2 and the external device are electrically separated. In this case, the external device may be a charger in a charging cycle for supplying power to the battery 10 to charge the battery, and be a load in a discharge cycle in which the battery 10 delivers power to the external device.

The current sensor 30 is connected in series on the current path between the battery 10 and the external device. The current sensor 30 may measure a battery current flowing through the battery 10, i.e., a charging current and a discharge current, and transmit the measurement result to the BMS 40.

The BMS 40 includes a measuring unit 41, a storage unit 43, and a control unit 45. The battery diagnosis apparatus 1 shown in FIG. 1 may correspond to the BMS 40 shown in FIG. 2. Specifically, the functions which are performed by the measuring unit 110, the storage unit 130, and the control unit 150 of the battery diagnosis apparatus 1 may correspond to the functions which are performed by the measuring unit 41, the storage unit 43, and the control unit 45 of the BMS 40, respectively. For example, the battery diagnosis apparatus 1 may be configured separately from the battery system 2. For another example, as shown in FIG. 2, in the battery system 2, the BMS 40 may perform the function of the battery diagnosis apparatus 1.

The measuring unit 41 may be electrically connected between both terminals of the battery 10 so as to be able to measure the battery current, the battery voltage, and the battery temperature value. For example, the measuring unit 41 may be configured with an ASIC (Application Specific Integrated Circuit) for monitoring the battery 10 and measuring battery data (such as voltage and current) corresponding to the state of the battery 10.

For example, the measuring unit 41 may collect battery voltages by sensing the voltage value between both terminals of the battery 10. The measuring unit 41 may receive the battery current value from the current sensor 30. The measuring unit 41 may receive the battery temperature value measured by the temperature sensor (not shown in the drawings) positioned inside or near the battery 10. The measuring unit 41 may transmit the battery voltage value, the battery current value, and the battery temperature value to the control unit 150.

In the storage unit 43, the internal resistance value and environment data of the battery 10 may be stored. The environment data may include information on environmental factors affecting the internal resistance (DCIR), such as the battery temperature and the state of charge (SOC).

At each diagnosis time of diagnosing defects of the battery 10, an internal resistance value which is calculated by the control unit 45 on the basis of at least one of a battery voltage, a battery current, and a battery temperature may be stored in the storage unit 43. In the storage unit 43, the state of charge (SOC) which is estimated by the control unit 45 on the basis of at least one of the battery voltage and the battery current may be stored. Further, at each diagnosis time of diagnosing defects of the battery, the control unit 45 may store the battery voltage value, the battery current value, and the battery temperature value received from the measuring unit 41, in the storage unit 43.

When a diagnosis time (N) according to the predetermined condition comes, the control unit 45 calculates a moving average $MA_N$, an upper band threshold $UB_N\_Th$, a lower band threshold $LB_N\_Th$, and an internal resistance ($DCIR_N$) value corresponding to the diagnosis time (N). Further, the control unit 45 may diagnose the state of the battery 10 by comparing the internal resistance ($DCIR_N$) value with the upper band threshold $UB_N\_Th$ and the lower band threshold $LB_N\_Th$.

First, the control unit 45 may determine a sample set by extracting a plurality of diagnosis times which is included in the predetermined number of samples SN when an environment data item belongs to an environment section including the environment data item of a predetermined diagnosis time (N) among a plurality of environment sections and diagnosis times are counted from the diagnosis time (N) toward the previous diagnosis times. At this time, the number of samples SN may be the number of a plurality of diagnosis times which is included in a sample set, and be set to an optimal number based on experiments and so on. A sample set may be a set of some of a plurality of past diagnosis times constituting a population, and be a set for calculating a moving average MA, a standard deviation averages $\sigma\_ave$, and so on to be described below.

For example, it is assumed that the environment data includes both of the battery temperature and the state of charge (SOC) and the number of samples SN is 5. In the above Table 1, the control unit 45 may determine a sample set by extracting the (N-1)-th diagnosis time, the (N-2)-th diagnosis time, the (N-3)-th diagnosis time, the (N-5)-th diagnosis time, and the (N-7)-th diagnosis time which correspond to 5 which is the number of samples SN when counting diagnosis times from the diagnosis time (N) toward the previous diagnosis times while belonging to an environment (the range from 21°C to 40°C and the range from 51% to 70%) similar to that at the current diagnosis time (N), i.e., the N-th diagnosis time.

The control unit 45 may calculate a moving average $MA_N$ which is the average of the internal resistance values of the sample set. For example, referring to the above Table 1 and the above Equation 2, the control unit may calculate a moving average ($MA_N$) 22.4 corresponding to the diagnosis time (N) by averaging the plurality of internal resistance values ($25\,\Omega$, $23\,\Omega$, $20\,\Omega$, $21\,\Omega$, and $23\,\Omega$) corresponding to the plurality of diagnosis times (N-7, N-5, N-3, N-2, and N-1) included in the sample set, respectively.

For example, referring to the above Table 1 and the above Table 3, the control unit 45 may calculate a standard deviation average $\sigma_{N\_ave}$ (1.69) corresponding to the diagnosis time (N) on the basis of the standard deviations ($\sigma_{N-7}$, $\sigma_{N-5}$, $\sigma_{N-3}$, $\sigma_{N-2}$, and $\sigma_{N-1}$) corresponding to the plurality of diagnosis times (N-7, N-5, N-3, N-2, and N-1) included in the sample set, respectively.

The control unit 45 determines an upper band threshold $UB_N\_Th$ and a lower band threshold $LB_N\_Th$ which are reference values for diagnosing defects of the battery at the current diagnosis time (N), i.e., the N-th diagnosis time, on the basis of the internal resistance values ($DCIR_N$) calculated at the plurality of diagnosis times (N-7, N-5, N-3, N-2, and N-1) included in the sample set, respectively.

The control unit 45 may calculate an upper band threshold $UB_N\_Th$ larger than the moving average $MA_N$ by a predetermined value and a lower band threshold $LB_N\_Th$ smaller than the moving average $MA_N$ by a predetermined value. According to the exemplary embodiment, the control unit 45 may calculate a first error value by multiplying the standard deviation average $\sigma_{N\_ave}$ by the predetermined first multiple, and calculate an upper band threshold $UB_N\_Th$ by adding the first error value to the moving average $MA_N$. Also, the control unit 45 may calculate a second error value by multiplying the standard deviation average $\sigma_{N\_ave}$ by the predetermined second multiple, and calculate a lower band threshold $LB_N\_Th$ by subtracting the second error value from the moving average $MA_N$. In this case, the first multiple and the second multiple may be the same, but are not limited thereto, and may be set to various multiples.

According to the exemplary embodiment, the control unit 45 may calculate an error value E ($= \sigma_{N\_ave} \times Q$) by multiplying the standard deviation average $\sigma_{N\_ave}$ which is the average of the standard deviations of the sample set and a predetermined multiple Q together. For example, it is assumed that the multiple Q is a natural number 3.

The control unit 45 may calculate an upper band threshold ($UB_N\_Th$) 27.47 by adding the error value E ($= \sigma_{N\_ave} \times Q = 1.69 \times 3$) to the moving average $MA_N$ ($= 22.4$) of the sample set, as shown in the above Equation 3. Also, the control unit 150 may calculate a lower band threshold ($LB_N\_Th$) 17.33 by subtracting the error value E ($= \sigma_{N\_ave} \times Q = 1.69 \times 3$) from the moving average $MA_N$ ($= 22.4$) of the sample set, as shown in the above Equation 4. In this case, the multiple Q may be a value for reflecting a predetermined error, and may be set to various values by experiments.

Subsequently, the control unit 45 may diagnose defects of the battery 10 by comparing the internal resistance ($DCIR_N$) value corresponding to the N-th diagnosis time with the upper band threshold $UB_N\_Th$ and the lower band threshold $LB_N\_Th$ corresponding to the N-th diagnosis time.

According to the exemplary embodiment, when the internal resistance ($DCIR_N$) value exceeds the upper band threshold $UB_N\_Th$, the control unit 45 may diagnose that a disconnection defect DD has occurred at, at least one of the plurality of battery cells included in the battery 10. When the internal resistance ($DCIR_N$) value is smaller than the lower band threshold $LB_N\_Th$, the control unit 45 may diagnose that a short defect SD has occurred at, at least one of the plurality of battery cells included in the battery 10. In other words, when the internal resistance ($DCIR_N$) value is out of a normal range from the lower band threshold $LB_N\_Th$ to the upper band threshold $UB_N\_Th$, the control unit 45 may diagnose that a defect (a disconnection defect or a short defect) has occurred in the battery 10. Also, when the internal resistance ($DCIR_N$) value is in the normal range, the control unit 45 may diagnose that the state of the battery 10 is normal.

For example, as described above through Table 1, Table 3, and Equation 1 to Equation 4, 30 ($\Omega$), 27.47, and 17.33 may be calculated as the internal resistance value ($DCIR_N$), the upper band threshold $UB_N\_Th$, and the lower band threshold $LB_N\_Th$ corresponding to the N-th diagnosis time, respectively. In this case, since the internal resistance value ($DCIR_N = 30$) exceeds the upper band threshold ($UB_N\_Th = 27.47$), the control unit 45 may diagnose a disconnection defect of the battery 10.

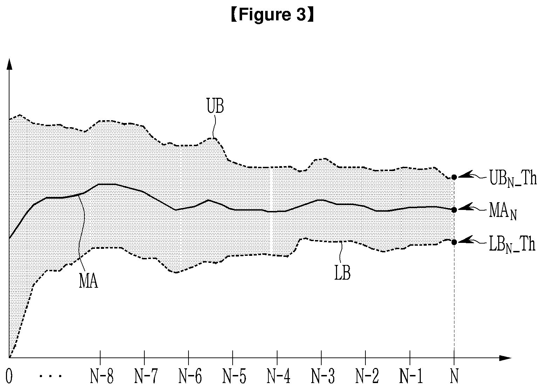

FIG. 3 is a drawing illustrating an example of a cumulative display of moving averages, upper band thresholds, and lower band thresholds calculated at a plurality of diagnosis times, respectively.

Hereinafter, on the basis of FIG. 1 to FIG. 3, Table 1, and Table 3, an example of calculating a moving average $MA_N$, an upper band threshold $UB_N\_Th$, and a lower band threshold $LB_N\_Th$ will be described.

Referring to FIG. 3, the BMS 40 may determine a sample set by extracting a plurality of diagnosis times close to a predetermined diagnosis time (N) while being in environments similar to that of the diagnosis time (N). The BMS 40 may calculate an upper band threshold $UB_N\_Th$ and a lower band threshold $LB_N\_Th$ corresponding to the diagnosis time (N), on the basis of the moving average $MA_N$ which is the average of the plurality of internal resistance values included in the sample set and the standard deviation average $\sigma_{N\_ave}$ which is the average of the plurality of standard deviations.

According to the exemplary embodiment, first, the BMS 40 may extract the (N-1)-th diagnosis time, the (N-2)-th diagnosis time, the (N-3)-th diagnosis time, the (N-5)-th diagnosis time, and the (N-7)-th diagnosis time which corresponding to 5 which is the number of samples SN when counting diagnosis times from a predetermined diagnosis time (N) toward the previous diagnosis times while belonging to an external environment (the range from 21°C to 40°C and the range from 51% to 70%) similar to that of the diagnosis time (N).

Subsequently, the BMS 40 may average the plurality of internal resistance values (25 $\Omega$, 23 $\Omega$, 20 $\Omega$, 21 $\Omega$, and 23 $\Omega$) corresponding to the plurality of extracted diagnosis times (N-7, N-5, N-3, N-2, and N-1), respectively, thereby calculating a moving average 22.4 $\Omega$ ($= (25 \Omega + 23 \Omega + 20 \Omega + 21 \Omega + 23 \Omega) / 5$) corresponding to the diagnosis time (N).

Through Table 3, Equation 3, and Equation 4 described above, the BMS 40 may calculate an upper band threshold (27.47) and a lower band threshold (17.33).

Subsequently, the BMS 40 may diagnose defects of the battery 10 by comparing the internal resistance ($DCIR_N$) value with the upper band threshold $UB_N\_Th$ and the lower band threshold $LB_N\_Th$. In this case, for example, it is assumed that the internal resistance ($DCIR_N$) is 30 $\Omega$. Since the internal resistance value ($DCIR_N = 30$) exceeds the upper band threshold ($UB_N\_Th = 27.47$), the BMS 40 may diagnose a disconnection defect of the battery.

An internal resistance band (DCIR Band) shown in FIG. 3 may be derived by connecting moving averages MA, upper band thresholds UB_Th, and lower band thresholds LB_Th calculated at the plurality of diagnosis times, respectively. The internal resistance band (DCIR Band) may show a transition of the internal resistance value which changes as the battery 10 is used.

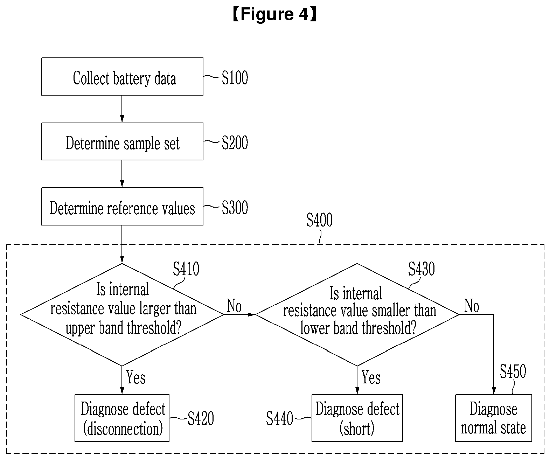

FIG. 4 is a flow chart for explaining a battery diagnosis method according to an exemplary embodiment.

Hereinafter, referring to FIG. 1 to FIG. 4, a battery diagnosis method, and a battery diagnosis apparatus and a battery system for providing the method will be described. The battery diagnosis method which is performed in the battery system 2 to be described below may be equally applied to the battery diagnosis apparatus 1.

First, the BMS 40 collects battery data (S100). In this case, the battery data may include at least one of a battery voltage which is the voltage between both terminals of the battery 10, a battery temperature, and a battery current which is a current flowing through the battery 10.

For example, the battery voltage and the battery current may be battery data necessary to calculate the internal resistance (DCIR; Direct Current Internal Resistance) or state of charge (SOC) of the battery. The battery temperature may be battery data necessary to determine an environment section to be described below.

Subsequently, the BMS 40 extracts a plurality of diagnosis times which is close to a predetermined diagnosis time (N) while being in an environment similar to that at the diagnosis time (N), to determine a sample set (S200).

The BMS 40 determines a sample set by extracting a plurality of diagnosis times satisfying (1) a first condition that environment data should belong to a predetermined environment section to which the environment data at a predetermined diagnosis time (N), i.e., the N-th diagnosis time belongs, and (2) a second condition that the plurality of diagnosis times should correspond to the predetermined number of samples SN when counting diagnosis times from the N-th diagnosis time toward the previous diagnosis times.

For example, it is assumed that the environment data includes both of the battery temperature and the state of charge (SOC) and the number of samples SN is 5. In the above Table 1, the BMS 40 may determine a sample set by extracting the (N-1)-th diagnosis time, the (N-2)-th diagnosis time, the (N-3)-th diagnosis time, the (N-5)-th diagnosis time, and the (N-7)-th diagnosis time which correspond to 5 which is the number of samples SN when counting diagnosis times from the diagnosis time (N) toward the previous diagnosis times while belonging to an environment (the range from 21°C to 40°C and the range from 51% to 70%) similar to that at the N-th diagnosis time.

Subsequently, the BMS 40 determines reference values for diagnosing defects of the battery 10 (S300). According to the exemplary embodiment, the reference values may include an upper band threshold $UB_N\_Th$ and a lower band threshold $LB_N\_Th$.

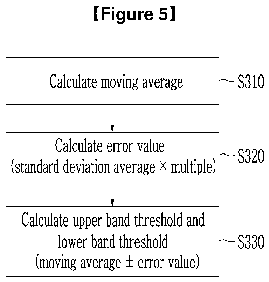

In STEP S300, referring to FIG. 5, the BMS 40 calculates the moving average $MA_N$ of the sample set by averaging the plurality of internal resistance values corresponding to the plurality of diagnosis times belonging to the sample set, respectively (S310).

Referring to the above Table 1 and the above Equation 2, the BMS 40 may calculate a moving average ($MA_N$) 22.4 corresponding to the diagnosis time (N) by averaging the plurality of internal resistance values (25 Ω, 23 Ω, 20 Ω, 21 Ω, and 23 Ω) corresponding to the plurality of diagnosis times (N-7, N-5, N-3, N-2, and N-1) included in the sample set, respectively.

In STEP S300, the BMS 40 calculates an error value E on the basis of the standard deviation average $\sigma_{N\_ave}$ of the sample set (S320).

For example, the standard deviation average $\sigma_{N\_ave}$ of the sample set may be calculated by averaging a plurality of standard deviations corresponding to the plurality of diagnosis times belonging to the sample set, respectively.

Referring to the above Table 1 and the above Table 3, the BMS 40 may calculate a standard deviation average $\sigma_{N\_ave}$ (1.69) corresponding to the diagnosis time (N), on the basis of the plurality of standard deviations ($\sigma_{N-7}$, $\sigma_{N-5}$, $\sigma_{N-3}$, $\sigma_{N-2}$, and $\sigma_{N-1}$) corresponding to the plurality of diagnosis times (N-7, N-5, N-3, N-2, and N-1) belonging to the sample set, respectively. Also, the BMS 40 may calculate an error value E (= $\sigma_{N\_ave} \times Q = 1.69 \times 3$) by multiplying the standard deviation average $\sigma_{N\_ave}$ and the predetermined multiple Q together. In this case, the multiple Q may be a value for reflecting a predetermined error, and may be set to various values by experiments. For example, it is assumed that the multiple Q is a natural number 3.

In STEP S300, the BMS 40 calculates an upper band threshold $UB_N\_Th$ and a lower band threshold $LB_N\_Th$ on the basis of the moving average $MA_N$ and the error value E of the sample set (S330).

Referring to the above Equation 3, the BMS 40 may calculate an upper band threshold ($UB_N\_Th$) 27.47 by adding the error value E (= $\sigma_{N\_ave} \times Q = 1.69 \times 3$) to the moving average $MA_N$ (= 22.4) of the sample set. Also, referring to the above Equation 4, the BMS 40 may calculate a lower band threshold ($LB_N\_Th$) 17.33 by subtracting the error value E (= $\sigma_{N\_ave} \times Q = 1.69 \times 3$) from the moving average $MA_N$ (= 22.4) of the sample set.

Subsequently, the BMS 40 diagnoses defects of the battery 10 by comparing the internal resistance ($DCIR_N$) value corresponding to the diagnosis time (N) with the upper band threshold $UB_N\_Th$ and the lower band threshold $LB_N\_Th$ corresponding to the diagnosis time (N) (S400).

The BMS 40 may calculate an internal resistance ($DCIR_N$) value corresponding to the N-th diagnosis time, on the basis of a battery voltage which is the voltage between both terminals of a battery and a battery current which is a current flowing through the battery. Also, the internal resistance ($DCIR_N$) value may be calculated in STEP S200 or STEP S300; however, the calculation time thereof is not limited as long as it is calculated before STEP S400 which is the diagnosis time.

For example, the BMS 40 may calculate the voltage difference between a battery voltage V1 corresponding to a first time when charging starts and a battery voltage V2 corresponding to a second time that is a predetermined time later from the first time ($\Delta V = |V1 - V2|$). The BMS 40 may calculate an internal resistance ($DCIR_N$) value on the basis of a charging current I flowing through the battery 10 and the voltage difference $\Delta V$. For example, it is assumed that 30 $\Omega$ is calculated as the internal resistance ($DCIR_N$) value corresponding to the N-th diagnosis time.

In STEP S400, the BMS 40 determines whether the internal resistance ($DCIR_N$) value exceeds the upper band threshold $UB_N\_Th$ (S410).

In STEP S400, when the determination result in STEP S410 is yes, the BMS 40 diagnoses that a disconnection defect has occurred at, at least one of the plurality of battery cells included in the battery 10 (S420).

For example, when the parallel connection between some battery cells of the plurality of battery cells connected in parallel is broken, the internal resistance value of the battery 10 may increase.

In STEP S400, when the determination result in STEP S410 is no, the BMS 40 determines whether the internal resistance value ($DCIR_N$) is smaller than the lower band threshold $LB_N\_Th$ (S430).

In STEP S400, when the determination result in STEP S430 is yes, the BMS 40 diagnoses that a short defect has occurred at, at least one of the plurality of battery cells included in the battery 10 (S440).

For example, when some battery cells of the plurality of battery cells connected in parallel are short-circuited, the internal resistance value which is the total resistance of the battery 10 may decrease.

In STEP S400, when the determination result in STEP S430 is no, the BMS 40 diagnoses that the state of the battery 10 is normal (S450).

Also, when the internal resistance ($DCIR_N$) value is out of the normal range from the lower band threshold $LB_N\_Th$ to the upper band threshold $UB_N\_Th$, the BMS 40 may diagnose the state of the battery 10 as a defect (a disconnection defect or a short defect). Further, when the internal resistance ($DCIR_N$) value is in the normal range, the BMS 40 may diagnose that the state of the battery 10 is normal.

While this invention has been described in connection with what is presently considered to be practical exemplary embodiments, it is to be understood that the invention is not limited to the disclosed embodiments. On the contrary, it is intended to cover various modifications and equivalent arrangements included within the scope of the appended claims.

**Claims**

1. A battery diagnosis apparatus (1) comprising:

   a measuring unit (110) that measures a battery voltage which is the voltage between both terminals of a battery, a battery current that is a current flowing through the battery, and a battery temperature which is the temperature of the battery; and
   a storage unit (130)
   that stores an internal resistance value calculated on the basis of the battery voltage and the battery current, and an environment data item which is a factor affecting the internal resistance value, at each diagnosis time of diagnosing defects of the battery; **characterised in that** the apparatus further comprises:

   a control unit (150) that extracts, at each diagnosis time, a plurality of diagnosis times satisfying a first condition that environment data corresponding to environment data at the diagnosis time in a predetermined range should be included, and a second condition that the plurality of diagnosis times should be previous diagnosis times corresponding to a predetermined number of samples from the diagnosis time, and calculates a moving average which is the average of a plurality of internal resistance values corresponding to the plurality of diagnosis times, respectively, and diagnoses defects of the battery by comparing the internal resistance value, which is calculated at each diagnosis time, with an upper band threshold larger than the moving average by a predetermined value and a lower band threshold smaller than the moving average by a predetermined value,
   wherein the environment data includes at least one of the state of charge, SOC, of the battery estimated by a predetermined method, and the battery temperature.

2. The battery diagnosis apparatus of claim 1, wherein
   the control unit (150) performs the following:

   calculating an error value by multiplying a standard deviation average which is the average of a plurality of standard deviations corresponding to the plurality of diagnosis times, respectively, by a predetermined multiple;
   calculating the upper band threshold by adding the error value to the moving average; and

calculating the lower band threshold by subtracting the error value from the moving average.

3. The battery diagnosis apparatus of claim 1, wherein
the control unit (150) determines that the first condition is satisfied, when a battery temperature at a predetermined diagnosis time belongs to a predetermined temperature range including a battery temperature at the diagnosis time among a plurality of temperature ranges set at a predetermined temperature interval.

4. The battery diagnosis apparatus of claim 1, wherein
the control unit (150) determines that the first condition is satisfied, when the state of charge at a predetermined diagnosis time belongs to a predetermined state-of-charge range including the state of charge at the diagnosis time among a plurality of state-of-charge ranges set at a predetermined state-of-charge interval.

5. The battery diagnosis apparatus of claim 1, wherein
when the internal resistance value exceeds the upper band threshold, the control unit (150) diagnoses that a disconnection defect has occurred at, at least one of a plurality of battery cells included in the battery (10).

6. The battery diagnosis apparatus of claim 1, wherein
when the internal resistance value is smaller than the lower band threshold, the control unit (150) diagnoses that a short defect has occurred at, at least one of a plurality of battery cells included in the battery (10).

7. The battery diagnosis apparatus of claim 1, wherein
when the internal resistance value belongs to a range from the lower band threshold to the upper band threshold, the control unit (150) diagnoses that a plurality of battery cells included in the battery is normal.

8. A battery system (2) comprising:

a battery (10) that includes a plurality of battery cells;
a measuring unit (41) that measures a battery voltage which is the voltage between both terminals of the battery, a battery current that is a current flowing through the battery, and a battery temperature which is the temperature of the battery; and
a storage unit (43) that stores an internal resistance value calculated on the basis of the battery voltage and the battery current, and an environment data item which is a factor affecting the internal resistance value, at each diagnosis time of diagnosing defects of the battery; **characterised in that** the battery system further comprises:

a control unit (45) that extracts, at each diagnosis time, a plurality of diagnosis times satisfying a first condition that environment data corresponding to environment data at the diagnosis time in a predetermined range should be included, and a second condition that the plurality of diagnosis times should be previous diagnosis times corresponding to a predetermined number of samples from the diagnosis time, and calculates a moving average which is the average of a plurality of internal resistance values corresponding to the plurality of diagnosis times, respectively, and diagnoses defects of the battery by comparing the internal resistance value calculated at each diagnosis time with an upper band threshold larger than the moving average by a predetermined value and a lower band threshold smaller than the moving average by a predetermined value, wherein the environment data includes at least one of the state of charge, SOC, estimated by a predetermined method, and the battery temperature.

9. The battery system of claim 8, wherein
the control unit (45) performs the following:

calculating an error value by multiplying a standard deviation average which is the average of a plurality of standard deviations corresponding to the plurality of diagnosis times, respectively, by a predetermined multiple;
calculating the upper band threshold by adding the error value to the moving average; and
calculating the lower band threshold by subtracting the error value from the moving average.

10. A battery diagnosis method comprising:

a battery data collecting step (S100) of collecting measurement values of battery voltage which is the voltage between both terminals of a battery, battery current which is the current flowing through the battery, and battery temperature which is the temperature of the battery;

a sample set determining step (S200) of extracting a plurality of diagnosis times satisfying a first condition that environment data corresponding to environment data at the diagnosis time in a predetermined range should be included, and a second condition that the plurality of diagnosis times should be previous diagnosis times corresponding to a predetermined number of samples from the diagnosis time;

a reference value determining step (S300) of calculating a moving average which is the average of a plurality of internal resistance values corresponding to the plurality of diagnosis times, respectively, and an upper band threshold which is larger than the moving average by a predetermined value, and a lower band threshold which is smaller than the moving average by a predetermined value; and

a defect diagnosis step (S400) of diagnosing defects of the battery by comparing an internal resistance value corresponding to the diagnosis time with the upper band threshold and the lower band threshold,

wherein the environment data includes at least one of the state of charge (SOC) of the battery estimated by a predetermined method, and the battery temperature.

11. The battery diagnosis method of claim 10, wherein
the reference value determining step (S300) performs the following:

calculating (S320) an error value by multiplying a standard deviation average which is the average of a plurality of standard deviations corresponding to the plurality of diagnosis times, respectively, by a predetermined multiple;
calculating (S330) the upper band threshold by adding the error value to the moving average; and
calculating (S330) the lower band threshold by subtracting the error value from the moving average.

12. The battery diagnosis method of claim 10, wherein
the sample set determining step (S200) determines that the first condition is satisfied, when a battery temperature at a predetermined diagnosis time belongs to a predetermined temperature range including a battery temperature at the diagnosis time among a plurality of temperature ranges set at a predetermined temperature interval.

13. The battery diagnosis method of claim 10, wherein
the sample set determining step (S200) determines that the first condition is satisfied, when the state of charge at a predetermined diagnosis time belongs to a predetermined state-of-charge range including the state of charge at the diagnosis time among a plurality of state-of-charge ranges set at a predetermined state-of-charge interval.

14. The battery diagnosis method of claim 10, wherein
when the internal resistance value corresponding to the diagnosis time exceeds the upper band threshold, the defect diagnosis step (S400) diagnoses that a disconnection defect has occurred at, at least one of a plurality of battery cells included in the battery.

15. The battery diagnosis method of claim 10, wherein
when the internal resistance value corresponding to the diagnosis time is smaller than the lower band threshold, the defect diagnosis step (S400) diagnoses that a short defect has occurred at, at least one of a plurality of battery cells included in the battery.


**Patentansprüche**

1. Batteriediagnosevorrichtung (1), umfassend:

eine Messeinheit (110), die eine Batteriespannung, welche die Spannung zwischen beiden Anschlüssen einer Batterie ist, einen Batteriestrom, welcher ein durch die Batterie fließender Strom ist, und eine Batterietemperatur misst, welche die Temperatur der Batterie ist; und
eine Speichereinheit (130), die einen auf der Grundlage der Batteriespannung und des Batteriestroms berechneten Innenwiderstandswert und ein Umgebungsdatenelement, welches ein den Innenwiderstandswert beeinflussender Faktor ist, zu jedem Diagnosezeitpunkt eines Diagnostizierens von Defekten der Batterie speichert;
**dadurch gekennzeichnet, dass** die Vorrichtung ferner umfasst:

eine Steuereinheit (150), die zu jedem Diagnosezeitpunkt eine Mehrzahl von Diagnosezeitpunkten extrahiert, welche eine erste Bedingung, dass Umgebungsdaten, die den Umgebungsdaten zu dem Diagnosezeitpunkt entsprechen, in einem vorbestimmten Bereich umfasst sein sollen, und eine zweite Bedingung erfüllen, dass die Mehrzahl von Diagnosezeitpunkten vorherige Diagnosezeitpunkte sein sollen, welche einer vorbestimmten Anzahl von Stichproben ab dem Diagnosezeitpunkt entsprechen, und einen gleitenden Mittelwert berechnet, welcher der Mittelwert einer Mehrzahl von Innenwiderstandswerten ist, welche jeweils der Mehrzahl von Diagnosezeitpunkten entsprechen, und durch ein Vergleichen des Innenwiderstandswerts, der zu jedem Diagnosezeitpunkt berechnet wird, mit einem oberen Bandschwellenwert, welcher um einen vorbestimmten Wert größer als der gleitende Mittelwert ist, und einem unteren Bandschwellenwert, welcher um einen vorbestimmten Wert kleiner als der gleitende Mittelwert ist, Defekte der Batterie diagnostiziert,

wobei die Umgebungsdaten wenigstens eines aus dem durch ein vorbestimmtes Verfahren geschätzten Ladezustand, SOC - State of Charge, der Batterie und der Batterietemperatur umfassen.

2. Batteriediagnosevorrichtung nach Anspruch 1, wobei die Steuereinheit (150) das Folgende durchführt:

Berechnen eines Fehlerwerts durch ein Multiplizieren eines Standardabweichungsmittelwerts, welcher der Mittelwert einer Mehrzahl von Standardabweichungen ist, welche jeweils der Mehrzahl von Diagnosezeitpunkten entsprechen, mit einem vorbestimmten Vielfachen;
Berechnen des oberen Bandschwellenwerts durch ein Addieren des Fehlerwerts zu dem gleitenden Mittelwert; und
Berechnen des unteren Bandschwellenwerts durch ein Subtrahieren des Fehlerwerts von dem gleitenden Mittelwert.

3. Batteriediagnosevorrichtung nach Anspruch 1, wobei die Steuereinheit (150) bestimmt, dass die erste Bedingung erfüllt ist, wenn eine Batterietemperatur zu einem vorbestimmten Diagnosezeitpunkt unter einer Mehrzahl von Temperaturbereichen, welche in einem vorbestimmten Temperaturintervall festgelegt sind, zu einem vorbestimmten Temperaturbereich gehört, welcher eine Batterietemperatur zu einem Diagnosezeitpunkt umfasst.

4. Batteriediagnosevorrichtung nach Anspruch 1, wobei die Steuereinheit (150) bestimmt, dass die erste Bedingung erfüllt ist, wenn der Ladezustand zu einem vorbestimmten Diagnosezeitpunkt unter einer Mehrzahl von Ladezustandsbereichen, welche in einem vorbestimmten Ladezustandsintervall festgelegt sind, zu einem vorbestimmten Ladezustandsbereich gehört, welcher den Ladezustand zu dem Diagnosezeitpunkt umfasst.

5. Batteriediagnosevorrichtung nach Anspruch 1, wobei, wenn der Innenwiderstandswert den oberen Bandschwellenwert überschreitet, die Steuereinheit (150) diagnostiziert, dass ein Unterbrechungsdefekt an wenigstens einer aus einer Mehrzahl von in der Batterie (10) umfassten Batteriezellen aufgetreten ist.

6. Batteriediagnosevorrichtung nach Anspruch 1, wobei, wenn der Innenwiderstandswert kleiner als der untere Bandschwellenwert ist, die Steuereinheit (150) diagnostiziert, dass ein Kurzschlussdefekt an wenigstens einer aus einer Mehrzahl von in der Batterie (10) umfassten Batteriezellen aufgetreten ist.

7. Batteriediagnosevorrichtung nach Anspruch 1, wobei, wenn der Innenwiderstandswert zu einem Bereich von dem unteren Bandschwellenwert zu dem oberen Bandschwellenwert gehört, die Steuereinheit (150) diagnostiziert, dass eine Mehrzahl von in der Batterie umfassten Batteriezellen normal ist.

8. Batteriesystem (2), umfassend:

eine Batterie (10), die eine Mehrzahl von Batteriezellen umfasst;
eine Messeinheit (41), die eine Batteriespannung, welche die Spannung zwischen beiden Anschlüssen der Batterie ist, einen Batteriestrom, welcher ein durch die Batterie fließender Strom ist, und eine Batterietemperatur misst, welche die Temperatur der Batterie ist; und
eine Speichereinheit (43), welche einen auf der Grundlage der Batteriespannung und des Batteriestroms berechneten Innenwiderstandswert und ein Umgebungsdatenelement, welches ein den Innenwiderstandswert beeinflussender Faktor ist, zu jedem Diagnosezeitpunkt eines Diagnostizierens von Defekten der Batterie speichert;
**dadurch gekennzeichnet, dass** das Batteriesystem ferner umfasst:

eine Steuereinheit (45), die zu jedem Diagnosezeitpunkt eine Mehrzahl von Diagnosezeitpunkten extrahiert, welche eine erste Bedingung, dass Umgebungsdaten, die den Umgebungsdaten zu dem Diagnosezeitpunkt entsprechen, in einem vorbestimmten Bereich umfasst sein sollen, und eine zweite Bedingung erfüllen, dass die Mehrzahl von Diagnosezeitpunkten vorherige Diagnosezeitpunkte sein sollen, welche einer vorbestimmten Anzahl von Stichproben ab dem Diagnosezeitpunkt entsprechen, und einen gleitenden Mittelwert berechnet, welcher der Mittelwert einer Mehrzahl von Innenwiderstandswerten ist, welche jeweils der Mehrzahl von Diagnosezeitpunkten entsprechen, und durch ein Vergleichen des Innenwiderstandswerts, der zu jedem Diagnosezeitpunkt berechnet wird, mit einem oberen Bandschwellenwert, welcher um einen vorbestimmten Wert größer als der gleitende Mittelwert ist, und einem unteren Bandschwellenwert, welcher um einen vorbestimmten Wert kleiner als der gleitende Mittelwert ist, Defekte der Batterie diagnostiziert, wobei die Umgebungsdaten wenigstens eines aus dem durch ein vorbestimmtes Verfahren geschätzten Ladezustand, SOC - State of Charge, und der Batterietemperatur umfassen.

9. Batteriesystem nach Anspruch 8, wobei die Steuereinheit (45) das Folgende durchführt:

Berechnen eines Fehlerwerts durch ein Multiplizieren eines Standardabweichungsmittelwerts, welcher der Mittelwert einer Mehrzahl von Standardabweichungen ist, welche jeweils der Mehrzahl von Diagnosezeitpunkten entsprechen, mit einem vorbestimmten Vielfachen;
Berechnen des oberen Bandschwellenwerts durch ein Addieren des Fehlerwerts zu dem gleitenden Mittelwert; und
Berechnen des unteren Bandschwellenwerts durch ein Subtrahieren des Fehlerwerts von dem gleitenden Mittelwert.

10. Batteriediagnoseverfahren, umfassend:

einen Batteriedatenerfassungsschritt (S100) eines Erfassens von Messwerten einer Batteriespannung, welche die Spannung zwischen beiden Anschlüssen einer Batterie ist, eines Batteriestroms, welcher der durch die Batterie fließende Strom ist, und einer Batterietemperatur, welche die Temperatur der Batterie ist;
einen Stichprobensatzbestimmungsschritt (S200) eines Extrahierens einer Mehrzahl von Diagnosezeitpunkten, welche eine erste Bedingung, dass Umgebungsdaten, die den Umgebungsdaten zu dem Diagnosezeitpunkt entsprechen, in einem vorbestimmten Bereich umfasst sein sollen, und eine zweite Bedingung erfüllen, dass die Mehrzahl von Diagnosezeitpunkten vorherige Diagnosezeitpunkte sein sollen, welche einer vorbestimmten Anzahl von Stichproben ab dem Diagnosezeitpunkt entsprechen;
einen Referenzwertbestimmungsschritt (S300) eines Berechnens eines gleitenden Mittelwerts, welcher der Mittelwert einer Mehrzahl von Innenwiderstandswerten ist, welche jeweils der Mehrzahl von Diagnosezeitpunkten entsprechen, sowie eines oberen Bandschwellenwerts, welcher um einen vorbestimmten Wert größer als der gleitende Mittelwert ist, und eines unteren Bandschwellenwerts, welcher um einen vorbestimmten Wert kleiner als der gleitende Mittelwert ist; und
einen Defektdiagnoseschritt (S400) eines Diagnostizierens von Defekten der Batterie durch ein Vergleichen eines dem Diagnosezeitpunkt entsprechenden Innenwiderstandswerts mit dem oberen Bandschwellenwert und dem unteren Bandschwellenwert,
wobei die Umgebungsdaten wenigstens eines aus dem durch ein vorbestimmtes Verfahren geschätzten Ladezustand (SOC - State of Charge) der Batterie und der Batterietemperatur umfassen.

11. Batteriediagnoseverfahren nach Anspruch 10, wobei der Referenzwertbestimmungsschritt (S300) das Folgende durchführt:

Berechnen (S320) eines Fehlerwerts durch ein Multiplizieren eines Standardabweichungsmittelwerts, welcher der Mittelwert einer Mehrzahl von Standardabweichungen ist, welche jeweils der Mehrzahl von Diagnosezeitpunkten entsprechen, mit einem vorbestimmten Vielfachen;
Berechnen (S330) des oberen Bandschwellenwerts durch ein Addieren des Fehlerwerts zu dem gleitenden Mittelwert; und
Berechnen (S330) des unteren Bandschwellenwerts durch ein Subtrahieren des Fehlerwerts von dem gleitenden Mittelwert.

12. Batteriediagnoseverfahren nach Anspruch 10, wobei der Stichprobensatzbestimmungsschritt (S200) bestimmt, dass die erste Bedingung erfüllt ist, wenn eine Batterietemperatur zu einem vorbestimmten Diagnosezeitpunkt unter einer Mehrzahl von Temperaturbereichen, welche in einem vorbestimmten Temperaturintervall festgelegt sind, zu einem vorbestimmten Temperaturbereich gehört, welcher eine Batterietemperatur zu dem Diagnosezeitpunkt umfasst.

13. Batteriediagnoseverfahren nach Anspruch 10, wobei der Stichprobensatzbestimmungsschritt (S200) bestimmt, dass die erste Bedingung erfüllt ist, wenn der Ladezustand zu einem vorbestimmten Diagnosezeitpunkt unter einer Mehrzahl von Ladezustandsbereichen, welche in einem vorbestimmten Ladezustandsintervall festgelegt sind, zu einem vorbestimmten Ladezustandsbereich gehört, welcher den Ladezustand zu dem Diagnosezeitpunkt umfasst.

**14.** Batteriediagnoseverfahren nach Anspruch 10, wobei, wenn der dem Diagnosezeitpunkt entsprechende Innenwiderstandswert den oberen Bandschwellenwert überschreitet, der Defektdiagnoseschritt (S400) diagnostiziert, dass ein Unterbrechungsdefekt an wenigstens einer aus einer Mehrzahl von in der Batterie umfassten Batteriezellen aufgetreten ist.

**15.** Batteriediagnoseverfahren nach Anspruch 10, wobei, wenn der dem Diagnosezeitpunkt entsprechende Innenwiderstandswert kleiner als der untere Bandschwellenwert ist, der Defektdiagnoseschritt (S400) diagnostiziert, dass ein Kurzschlussdefekt an wenigstens einer aus einer Mehrzahl von in der Batterie umfassten Batteriezellen aufgetreten ist.

**Revendications**

**1.** Appareil de diagnostic de batterie (1) comprenant :

une unité de mesure (110) qui mesure une tension de batterie qui est la tension entre les deux bornes d'une batterie, un courant de batterie qui est un courant circulant à travers la batterie, et une température de batterie qui est la température de la batterie ; et
une unité de stockage (130) qui stocke une valeur de résistance interne calculée sur la base de la tension de batterie et du courant de batterie, et un élément de données d'environnement qui est un facteur affectant la valeur de résistance interne, à chaque moment de diagnostic de défauts de diagnostic de la batterie ; **caractérisé en ce que** l'appareil comprend en outre :

une unité de commande (150) qui extrait, à chaque moment de diagnostic, une pluralité de moments de diagnostic satisfaisant une première condition selon laquelle des données d'environnement correspondant à des données d'environnement au moment de diagnostic dans une plage prédéterminée doivent être incluses, et une deuxième condition selon laquelle la pluralité de moments de diagnostic doivent être des moments de diagnostic précédents correspondant à un nombre prédéterminé d'échantillons à partir du moment de diagnostic, et calcule une moyenne mobile qui est la moyenne d'une pluralité de valeurs de résistance interne correspondant à la pluralité de moments de diagnostic, respectivement, et diagnostique des défauts de la batterie par la comparaison de la valeur de résistance interne, qui est calculée à chaque moment de diagnostic, avec un seuil de bande supérieure supérieur à la moyenne mobile d'une valeur prédéterminée et un seuil de bande inférieure inférieur à la moyenne mobile d'une valeur prédéterminée, dans lequel les données environnementales incluent au moins un parmi l'état de charge, SOC, de la batterie estimé par un procédé prédéterminé, et la température de la batterie.

**2.** Appareil de diagnostic de batterie selon la revendication 1, dans lequel
l'unité de commande (150) effectue ce qui suit :

le calcul d'une valeur d'erreur par la multiplication d'une valeur moyenne d'écart type, qui est la moyenne d'une pluralité d'écarts types correspondant à la pluralité de moments de diagnostic, respectivement, par un multiple prédéterminé ;
le calcul du seuil de bande supérieure par l'ajout de la valeur d'erreur à la moyenne mobile ; et
le calcul du seuil de bande inférieure par la soustraction de la valeur d'erreur de la moyenne mobile.

**3.** Appareil de diagnostic de batterie selon la revendication 1, dans lequel
l'unité de commande (150) détermine que la première condition est satisfaite lorsqu'une température de batterie à un moment de diagnostic prédéterminé s'inscrit dans une plage de température prédéterminée incluant une température de batterie au moment de diagnostic parmi une pluralité de plages de température définies à un intervalle de température prédéterminé.

**4.** Appareil de diagnostic de batterie selon la revendication 1, dans lequel
l'unité de commande (150) détermine que la première condition est satisfaite lorsque l'état de charge à un moment de diagnostic prédéterminé s'inscrit dans une plage d'état de charge prédéterminée incluant l'état de charge au moment du diagnostic parmi une pluralité de plages d'état de charge définies à un intervalle d'état de charge prédéterminé.

5. Appareil de diagnostic de batterie selon la revendication 1, dans lequel
lorsque la valeur de résistance interne dépasse le seuil de bande supérieure, l'unité de commande (150) diagnostique qu'un défaut de déconnexion s'est produit au niveau d'au moins un parmi une pluralité d'éléments de batterie inclus dans la batterie (10).

6. Appareil de diagnostic de batterie selon la revendication 1, dans lequel
lorsque la valeur de résistance interne est inférieure au seuil de bande inférieure, l'unité de commande (150) diagnostique qu'un défaut de court-circuit s'est produit au niveau d'au moins un parmi une pluralité d'éléments de batterie inclus dans la batterie (10).

7. Appareil de diagnostic de batterie selon la revendication 1, dans lequel
lorsque la valeur de résistance interne s'inscrit dans une plage allant du seuil de bande inférieure au seuil de bande supérieure, l'unité de commande (150) diagnostique qu'une pluralité d'éléments de batterie inclus dans la batterie est normale.

8. Système de batterie (2) comprenant :

une batterie (10) qui inclut une pluralité d'éléments de batterie ;
une unité de mesure (41) qui mesure une tension de batterie qui est la tension entre les deux bornes de la batterie, un courant de batterie qui est un courant circulant à travers la batterie, et une température de batterie qui est la température de la batterie ; et
une unité de stockage (43) qui stocke une valeur de résistance interne calculée sur la base de la tension de batterie et du courant de batterie, et un élément de données d'environnement qui est un facteur affectant la valeur de résistance interne, à chaque moment de diagnostic de défauts de diagnostic de la batterie ; **caractérisé en ce que** le système de batterie comprend en outre :

une unité de commande (45) qui extrait, à chaque moment de diagnostic, une pluralité de moments de diagnostic satisfaisant une première condition selon laquelle des données d'environnement correspondant à des données d'environnement au moment de diagnostic dans une plage prédéterminée doivent être incluses, et une deuxième condition selon laquelle la pluralité de moments de diagnostic doivent être des moments de diagnostic précédents correspondant à un nombre prédéterminé d'échantillons à partir du moment de diagnostic, et calcule une moyenne mobile qui est la moyenne d'une pluralité de valeurs de résistance interne correspondant à la pluralité de moments de diagnostic, respectivement, et diagnostique des défauts de la batterie par la comparaison de la valeur de résistance interne, calculée à chaque moment de diagnostic, avec un seuil de bande supérieure supérieur à la moyenne mobile d'une valeur prédéterminée et un seuil de bande inférieure inférieur à la moyenne mobile d'une valeur prédéterminée,
dans lequel les données environnementales incluent au moins un parmi l'état de charge, SOC, estimé par un procédé prédéterminé, et la température de batterie.

9. Système de batterie selon la revendication 8, dans lequel
l'unité de commande (45) effectue ce qui suit :

le calcul d'une valeur d'erreur par la multiplication d'une valeur moyenne d'écart type, qui est la moyenne d'une pluralité d'écarts types correspondant à la pluralité de moments de diagnostic, respectivement, par un multiple prédéterminé ;
le calcul du seuil de bande supérieure par l'ajout de la valeur d'erreur à la moyenne mobile ; et
le calcul du seuil de bande inférieure par la soustraction de la valeur d'erreur de la moyenne mobile.

10. Procédé de diagnostic de batterie comprenant :

une étape de collecte de données de batterie (S 1 00) consistant à collecter des valeurs de mesure de tension de batterie qui est la tension entre les deux bornes d'une batterie, de courant de batterie qui est le courant circulant à travers la batterie et de température de batterie qui est la température de la batterie ;
une étape de détermination d'ensemble d'échantillons (S200) consistant à extraire une pluralité de moments de diagnostic satisfaisant une première condition selon laquelle des données d'environnement correspondant à des données d'environnement au moment du diagnostic dans une plage prédéterminée doivent être incluses, et une deuxième condition selon laquelle la pluralité de moments de diagnostic doivent être des moments de diagnostic précédents correspondant à un nombre prédéterminé d'échantillons à partir du moment du diagnostic ;

une étape de détermination de valeur de référence (S300) consistant à calculer une moyenne mobile qui est la moyenne d'une pluralité de valeurs de résistance interne correspondant à la pluralité de moments de diagnostic, respectivement, et un seuil de bande supérieure qui est supérieur à la moyenne mobile d'une valeur prédéterminée, et un seuil de bande inférieure qui est inférieur à la moyenne mobile d'une valeur prédéterminée ; et

une étape de diagnostic de défaut (S400) consistant à diagnostiquer des défauts de la batterie par la comparaison d'une valeur de résistance interne correspondant au moment de diagnostic avec le seuil de bande supérieure et le seuil de bande inférieure, dans lequel les données environnementales incluent au moins un parmi l'état de charge (SOC) de la batterie estimé par un procédé prédéterminé, et la température de la batterie.

11. Procédé de diagnostic de batterie selon la revendication 10, dans lequel
l'étape de détermination de valeur de référence (S300) effectue ce qui suit :

le calcul (S320) d'une valeur d'erreur par la multiplication d'une valeur moyenne d'écart type, qui est la moyenne d'une pluralité d'écarts types correspondant à la pluralité de moments de diagnostic, respectivement, par un multiple prédéterminé ;

le calcul (S330) du seuil de bande supérieure par l'ajout de la valeur d'erreur à la moyenne mobile ; et

le calcul (S330) du seuil de bande inférieure par la soustraction de la valeur d'erreur de la moyenne mobile.

12. Procédé de diagnostic de batterie selon la revendication 10, dans lequel
l'étape de détermination d'ensemble d'échantillons (S200) détermine que la première condition est satisfaite lorsqu'une température de batterie à un moment de diagnostic prédéterminé s'inscrit dans une plage de température prédéterminée incluant une température de batterie au moment de diagnostic parmi une pluralité de plages de température définies à un intervalle de température prédéterminé.

13. Procédé de diagnostic de batterie selon la revendication 10, dans lequel
l'étape de détermination d'ensemble d'échantillons (S200) détermine que la première condition est satisfaite lorsque l'état de charge à un moment de diagnostic prédéterminé s'inscrit dans une plage d'état de charge prédéterminée incluant l'état de charge au moment du diagnostic parmi une pluralité de plages d'état de charge définies à un intervalle d'état de charge prédéterminé.

14. Procédé de diagnostic de batterie selon la revendication 10, dans lequel
lorsque la valeur de résistance interne correspondant au moment de diagnostic dépasse le seuil de bande supérieure, l'étape de diagnostic de défaut (S400) diagnostique qu'un défaut de déconnexion s'est produit au niveau d'au moins un parmi une pluralité d'éléments de batterie inclus dans la batterie.

15. Procédé de diagnostic de batterie selon la revendication 10, dans lequel
lorsque la valeur de résistance interne correspondant au moment de diagnostic est inférieure au seuil de bande inférieure, l'étape de diagnostic de défaut (S400) diagnostique qu'un défaut de court-circuit s'est produit au niveau d'au moins un parmi une pluralité d'éléments de batterie inclus dans la batterie.

【Figure 1】

1

Battery diagnosis apparatus

| Measuring unit | 110 |

| Control unit | 150 |

| Storage unit | 130 |

【Figure 2】

【Figure 3】

**【Figure 4】**

```
┌─────────────────────┐
│ Collect battery data │──── S100
└─────────────────────┘
           │
           ▼
┌─────────────────────┐
│ Determine sample set │──── S200
└─────────────────────┘
           │
           ▼
┌──────────────────────────┐
│ Determine reference values │──── S300
└──────────────────────────┘
```

S400

┌────────────────────────────────────────────────────────────────────────────────┐
(dashed box)

S410                                              S430

Is internal resistance value larger than upper band threshold?  ──No──▶  Is internal resistance value smaller than lower band threshold?  ──No──▶  S450

Yes                                               Yes

Diagnose defect (disconnection) ── S420          S440 ── Diagnose defect (short)          Diagnose normal state

【Figure 5】

Calculate moving average ～S310

Calculate error value
(standard deviation average × multiple) ～S320

Calculate upper band threshold and
lower band threshold
(moving average ± error value) ～S330

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220061918

- KR 1020220013571